# EUROPEAN PATENT APPLICATION

(11) **EP 4 835 128 A1**
(43) Date of publication of application: **04.11.2026**
(21) Application number: 23962775.5
(22) Date of filing: 29.12.2023
(51) Int. Cl.: C23C 14/32, H01M 4/64

(54) **METHOD FOR PREPARING COMPOSITE CURRENT COLLECTOR FOR LITHIUM BATTERY, AND DEVICE FOR PREPARING COMPOSITE CURRENT COLLECTOR FOR LITHIUM BATTERY**

(71) Applicant: Naxau New Materials Corporation, Jiaxing, Zhejiang 314200 (CN); Dong Guan Hanjing Nano Materials Ltd, Dongguan, Guangdong 523700 (CN)
(72) Inventor: GUO, Bei, Jiaxing, Zhejiang 314200 (CN); SHEN, Xuezhong, Jiaxing, Zhejiang 314200 (CN)
(74) Representative: Banse & Steglich Patentanwälte PartmbB
(86) International application number: PCT/CN2023/143216
(87) International publication number: WO 2025/138098

(57) **Abstract**

Disclosed are a method for preparing a composite current collector for a lithium battery and an apparatus for preparing the composite current collector for a lithium battery. The method comprises: evaporating a first target material to produce a first target material vapor; ionizing the first target material vapor to form a first ionized structure on a first side of a base film, wherein the first ionized structure comprises at least two ionic layers which respectively have different ionization rates; and evaporating a second target material to form a metal layer comprising the second target material on the first ionized structure.

## Description

### Field of the Invention

The present invention belongs to the field of composite current collectors of a lithium battery, and particularly relates to a method for preparing a composite current collector for a lithium battery and an apparatus for preparing the composite current collector for a lithium battery.

### Background

With the continuous growth of new energy vehicle industry, the demand of lithium ion batteries also rapidly rises. A current collector serving as one of indispensable components in the lithium ion batteries not only can bear active substances, but also can collect and output currents generated by active substances of electrodes. A composite current collector is a threelayer composite structure of metal-high polymer material-metal formed by stacking composite materials of metal atoms on both sides by taking raw material films such as PET/PP and the like as a base film through processes such as vacuum coating and the like. At present, one or combination of magnetron sputtering and evaporation coating is basically used as a common vacuum preparation mode. After an nm-level priming layer is formed on the surface by the magnetron sputtering, a metal layer is thickened by using the vacuum evaporation and the like. In the process, ensuring a good adhesive force between the base film and a coating layer is the key for subsequent stable operation of the composite current collector.

### Summary of the Invention

In view of this, the present application provides a method for preparing a composite current collector for a lithium battery and an apparatus for preparing the composite current collector for a lithium battery to enhance the bonding force between a base film and a subsequent metal layer and improve the internal stress of the film layer.

Examples of the present application provide a method for preparing a composite current collector for a lithium battery. The method comprises: evaporating a first target material to produce a first target material vapor; ionizing the first target material vapor to form a first ionized structure on a first side of a base film, wherein the first ionized structure comprises at least two ionic layers which respectively have different ionization rates; and evaporating a second target material to form a metal layer comprising the second target material on the first ionized structure.

In some examples, ionizing the first target material vapor to form the first ionized structure on the first side of the base film comprises: forming a first ionic layer on the first side of the base film; forming a second ionic layer on the first ionic layer; and forming a third ionic layer on the second ionic layer, wherein the ionization rates of the first, second and third ionic layers are different from each other.

In some examples, the ionization rates of the first, second and third ionic layers increase progressively.

In some examples, the ionization rates of the first, second and third ionic layers decrease progressively.

In some examples, the ionization rates of the first and third ionic layers are smaller than the ionization rate of the second ionic layer.

In some examples, the ionization rates of the first and third ionic layers are greater than the ionization rate of the second ionic layer.

In some examples, ionizing the first target material vapor to form the first ionized structure on the first side of the base film further comprises: forming a fourth ionic layer on the third ionic layer; forming a fifth ionic layer on the fourth ionic layer; and forming a sixth ionic layer on the fifth ionic layer, wherein the ionization rates of the fourth, fifth and sixth ionic layers are different from each other.

In some examples, the ionization rates of the fourth, fifth and sixth ionic layers increase progressively.

In some examples, the ionization rates of the fourth, fifth and sixth ionic layers decrease progressively.

In some examples, the ionization rates of the fourth and sixth ionic layers are smaller than the ionization rate of the fifth ionic layer.

In some examples, the ionization rates of the fourth and sixth ionic layers are greater than the ionization rate of the fifth ionic layer.

In some examples, the method further comprises: evaporating a third target material to produce a third target material vapor; ionizing the third target material vapor to form a second ionized structure on a second side of the base film, wherein the second side is opposite to the first side and the second ionized structure comprises at least two ionic layers which respectively have different ionization rates; and evaporating the second target material to form a metal layer comprising the second target material on the second ionized structure.

In some examples, forming the second ionized structure on the second side of the base film comprises: forming a seventh ionic layer on the second side of the base film; forming an eighth ionic layer on the seventh ionic layer; and forming a ninth ionic layer on the eighth ionic layer, wherein the ionization rates of the seventh, eighth and ninth ionic layers are different from each other.

In some examples, the ionization rates of the seventh, eighth and ninth ionic layers increase progressively.

In some examples, the ionization rates of the seventh, eighth and ninth ionic layers decrease progressively.

In some examples, the ionization rates of the seventh and ninth ionic layers are smaller than the ionization rate of the eighth ionic layer.

In some examples, the ionization rates of the seventh and ninth ionic layers are greater than the ionization rate of the eighth ionic layer.

In some examples, forming the second ionized structure on the second side of the base film further comprises: forming a tenth ionic layer on the ninth ionic layer; forming an eleventh ionic layer on the tenth ionic layer; and forming a twelfth ionic layer on the eleventh ionic layer, wherein the ionization rates of the tenth, eleventh and twelfth ionic layers are different from each other.

In some examples, the ionization rates of the tenth, eleventh and twelfth ionic layers increase progressively.

In some examples, the ionization rates of the tenth, eleventh and twelfth ionic layers decrease progressively.

In some examples, the ionization rates of the tenth and twelfth ionic layers are smaller than the ionization rate of the eleventh ionic layer.

In some examples, the ionization rates of the tenth and twelfth ionic layers are greater than the ionization rate of the eleventh ionic layer.

In some examples, the first, second and third target materials are the same, partially the same or different from each other.

In some examples, the first target material comprises aluminum oxide and the third target material comprises aluminum.

In some examples, the base film comprises any one or a mixture of more than one of polypropylene, polyethylene terephthalate, polybutylene terephthalate, polyethylene naphthalate, polyethylene, polystyrene, polyvinyl chloride, polyvinylidene fluoride, polytetrafluoroethylene, polyphenylene sulfide, polyphenylene oxide, polyacrylonitrile, cellulose acetate, polystyrene or polyimide.

In some examples, the first ionized structure comprises at least one of aluminum, copper, nickel, tin, zinc, chromium, iron, lithium, cobalt and oxides or alloys thereof, or at least one of silicon oxide, silicon carbide, silicon nitride, graphite, carbon nanotubes and carbon fibers.

In some examples, the thickness of the first ionized structure is less than 1,000 nm.

In some examples, the metal layer comprises at least one of aluminum, copper, lithium and oxides or alloys thereof.

In some examples, the thickness of the metal layer is smaller than 50 µm.

The examples of the present application provide an apparatus for preparing a composite current collector for a lithium battery, configured to perform the method. The apparatus comprises a conveying assembly, an evaporation assembly and an ionization device. The conveying assembly is used to convey a base film; and the evaporation assembly is arranged below the conveying assembly. The evaporation assembly is configured to evaporate a target material. The ionization device is arranged above the evaporation assembly. The ionization device is configured to ionize vapor of the target material to form at least two ionic layers on the base film, wherein the at least two ionic layers respectively have different ionization rates. The conveying assembly comprises conveying rollers. The conveying rollers are configured to bear the base film so as to enable a film to be coated of the base film to face towards the evaporation assembly and the ionization device. The conveying rollers comprise cooling components. The cooling components are configured to control the temperature of the base film when the base film is coated so as to avoid the base film from being overheat-shrunk and deformed due to the formation of the at least two ionic layers having different ionization rates.

The present application adjusts the ionization rate in the evaporation process to prepare an intermediate layer group between the outer metal layer and the base film layer, thereby enhancing the bonding force between the base film and the subsequent metal layer and improving the internal stress of the film layer. In the process of adjusting the ionization rate, the temperature in a vacuum chamber also changes along with the change of the ionization rate. Then the conveying rollers with the cooling components are matched to ensure that the base film cannot be continuously overheated and deformed in the circulating film coating process. Besides, the film layer group structure formed by different ionization rates is more uniform and compact than the composite current collector structure formed only by evaporation.

### Brief description of the drawings

The accompanying drawings are provided for further understanding of the present application, constitute a part of the description, and are intended to explain the present application together with the following specific implementations, rather than to limit the present application. In the drawings:
FIG. 1 illustrates a schematic view of an apparatus for preparing a composite current collector for a lithium battery according to an example of the present application;
FIG. 2 illustrates process steps of a method for preparing a composite current collector for a lithium battery according to an example of the present application;
FIG. 3 is a schematic diagram of a structure formed on a first side of a base film according to an example of the present application;
FIG. 4A is a structure diagram of a first ionized structure formed by a primary circulation according to an example of the present application;
FIG. 4B is a structure diagram of a first ionized structure formed by a secondary circulation according to an example of the present application;
FIG. 5 illustrates process steps for preparing a composite current collector for a lithium battery according to an example of the present application;
FIG. 6 is a schematic diagram of a structure formed on a second side of a base film according to an example of the present application;
FIG. 7A is a structure diagram of a second ionized structure formed by a primary circulation according to an example of the present application; and
FIG. 7B is a structure diagram of the second ionized structure formed by a secondary circulation according to an example of the present application.

### Detailed Description

The following disclosure provides various embodiments or illustrations that can be used to implement different features of the present disclosure. The assemblies and configured specific examples below are used to simplify the present disclosure. It is to be understood that such descriptions are merely illustrative and are not intended to limit the present disclosure. For example, in the following description, forming a first feature on or over a second feature may include certain example in which the first and second features are in direct contact with each other; and may also include examples in which additional assemblies are formed between the first and second features described above, such that the first and second features may not be in direct contact. In addition, the present disclosure may reuse assembly symbols and/or labels in various examples. Such reuse is intended for simplification and clarity and does not in itself dictate the relationship between different examples and/or configurations discussed.

Furthermore, spatially relative terms, such as "under", "below", "lower", "over", "above" and the like, may be used herein for convenience in describing the relationship of one assembly or feature relative to another or a plurality of assemblies or features illustrated in the figures. These spatially relative terms are intended to further encompass a variety of different orientations of an apparatus in use or operation in addition to the orientation illustrated in the figures. The apparatus may be otherwise oriented (e.g., rotated 90 degrees or at other orientations) and the spatially relative description vocabularies should make corresponding explanation accordingly.

Although the numerical ranges and parameters defining a broader scope of the present application are all approximations. The related numerical values in the specific examples are presented herein as precisely as possible. However, any numerical value essentially inevitably contains standard deviations caused by an individual measuring method. As used herein, "about" generally refers to actual numerical values within positive and negative 10%, 5%, 1% or 0.5% of a particular numerical value or range. Alternatively, the term "about" indicates that an actual numerical value falls within an acceptable standard deviation of an average value, subjecting to consideration by a person with common knowledge in the art to which the present application pertains. In addition to the examples or unless otherwise specified, all the ranges, amounts, numerical values and percentages (e.g., to describe amounts of materials, length of time, temperatures, operating conditions, quantitative proportions and the like) herein used are to be understood as modified by the term "about". Accordingly, unless indicated to the contrary, the numerical parameters set forth in the description and attached claims are approximations and may be changed as required. At least, these numerical parameters are to be understood as numerical values obtained by the indicated number of significant digits and a general carry method. Herein, numerical ranges are expressed from one endpoint to the other endpoint or between the two endpoints; unless otherwise indicated, all the numerical ranges recited herein are inclusive of the endpoints.

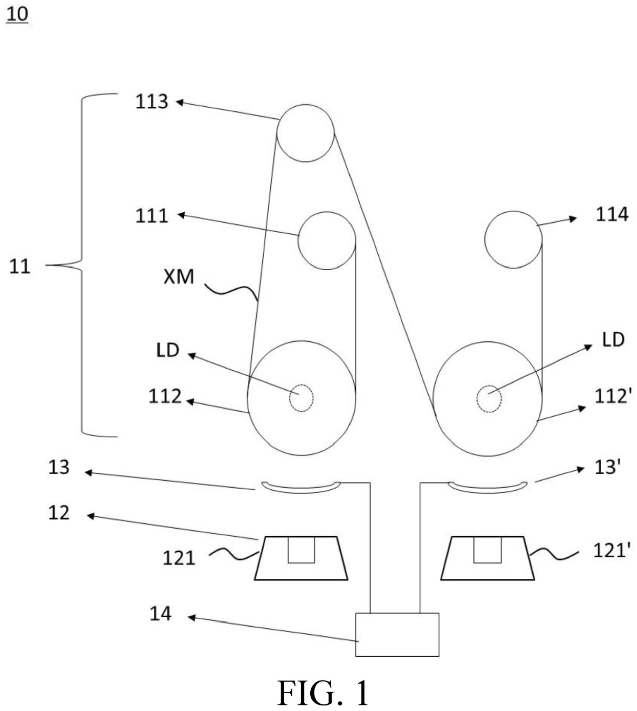

FIG. 1 illustrates a schematic view of an apparatus 10 for preparing a composite current collector for a lithium battery according to an example of the present application. In some examples, the apparatus 10 may individually or simultaneously coat both sides of a base film XM and the apparatus 10 includes a conveying assembly 11, an evaporation assembly 12 and ionization devices 13 and 13'.

The conveying assembly 11 is used to convey the base film XM. In certain examples, the conveying assembly 11 includes an unwinding roller 111, a conveying rollers 112 and 112', a transition roller 113 and a winding roller 114. The base film XM is unwound by the unwinding roller 111, guided by the conveying roller 112, the transition roller 113 and the conveying roller 112' in order, and finally wound by the winding roller 114. In some examples, cooling components LD are arranged in the conveying rollers 112 and 112'. The cooling components LD are configured to control the temperature of the base film XM when the base film XM is coated so as to avoid the base film XM from being overheat-shrunk and deformed due to the formation of the ionic layers having different ionization rates.

The evaporation assembly 12 is arranged below the conveying assembly 11. The evaporation assembly 12 is configured to evaporate a target material to produce a vapor including a target material component. In some examples, the evaporation assembly 12 includes crucibles 121 and 121' to bear the target material. In some examples, the evaporation assembly 12 further includes a target material transport device and a heating device (not shown in the figure). The target material transport device is configured to transport the target material into the crucibles 121 and 121'. The heating device is for example but not limited to an electronic gun to vaporize the target material in the crucibles 121 and 121'.

It should be noted that the present application is not limited to the specific implementation of the heating device and any vaporization of a target material to produce vapor shall fall within the scope of the present application. In some examples, the minimum distance between the crucibles 121 and 121' and the base film XM is controlled to be 200 mm.

The ionization devices 13 and 13' are arranged directly above the evaporation assembly 12. Specifically, the ionization device 13, the crucible 121 and the conveying roller 112 are located correspondingly, and the side of the base film XM born by the conveying roller 112 facing towards the ionization device 13 and the crucible 121 will be coated. In addition, the ionization device 13', the crucible 121' and the conveying roller 112' are located correspondingly, and the side of the base film XM born by the conveying roller 112' facing towards the ionization device 13' and the crucible 121' will be coated.

The ionization devices 13 and 13' are configured to ionize the target material vapor in the crucibles 121 and 121' respectively, thereby forming ionic layers on both sides of the base film XM. In some examples, the ionization devices 13 and 13' may be a circular tungsten wire structure or a spiral tungsten wire structure. In some examples, when the longest length of the evaporation assemblies 12 and 12' is L, the diameter of the ionization devices 13 and 13' is d, and the distance h between the ionization devices 13 and 13' and the evaporation assemblies 12 and 12' respectively satisfies the relationship: L<d≤(L+2h).

In some examples, the apparatus 10 further includes a control device 14, wherein the control device 14 is configured to control the ionization rate at which the target material vapor is ionized by the ionization devices 13 and 13'. The ionization rate γ is the ratio of ionized atoms to total evaporated atoms (0≤γ≤1). The ionization rate γ has direct influence on the hardness and corrosion resistance of a coating layer. The higher ionization rate indicates the denser coating layer and the better bonding force.

In some examples, the base film XM is a high polymer base film and includes any one or a mixture of more than one of polypropylene, polyethylene terephthalate, polybutylene terephthalate, polyethylene naphthalate, polyethylene, polystyrene, polyvinyl chloride, polyvinylidene fluoride, polytetrafluoroethylene, polyphenylene sulfide, polyphenylene oxide, polyacrylonitrile, cellulose acetate, polystyrene or polyimide and the like. In some examples, the thickness of the base film XM is 0-50 µm.

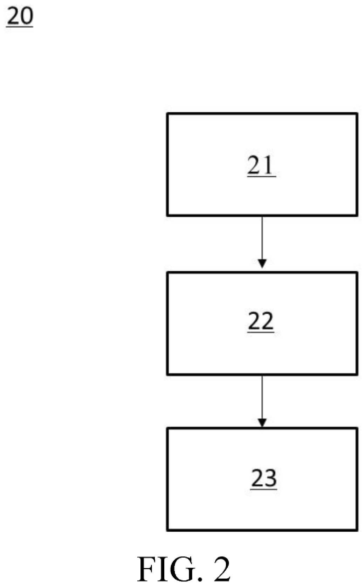

FIG. 2 illustrates process steps of a method 20 for preparing a composite current collector for a lithium battery according to an example of the present application. In some examples, the apparatus 10 shown in FIG. 1 may be used to perform the process steps of the method 20. The present application is not limited to being performed completely according to the process steps shown in FIG. 2, provided that substantially similar results are obtained. The method 20 may include steps 21, 22 and 23. In step 21, the first target material may be evaporated to produce a first target material vapor. In step 22, the first target material vapor may be ionized to form a first ionized structure on a first side of a base film. The first ionized structure may include at least two ionic layers which respectively have different ionization rates. In step 23, a second target material may be evaporated to form a metal layer including the second target material on the first ionized structure.

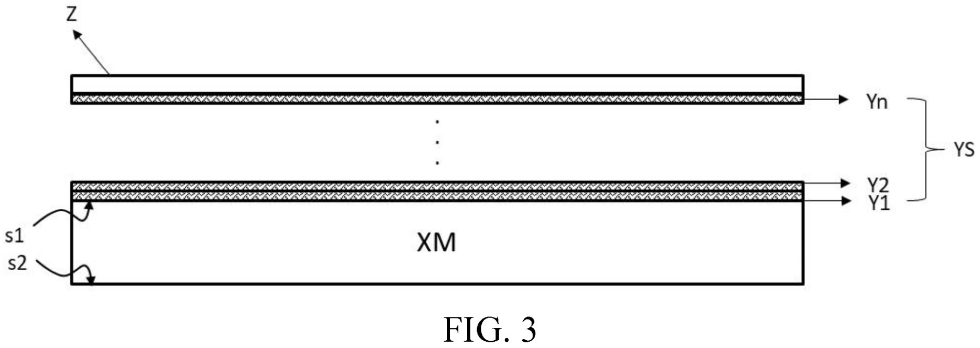

Referring to FIGs. 1, 2 and 3 together, FIG. 3 is a schematic diagram of a structure formed on a first side s1 of a base film XM according to an example of the present application. In the process shown in the method 20, a first target material is placed in a crucible 121 and vaporized by a heating device (for example but not limited to an electronic gun) to produce a vapor. In some examples, the evaporation assembly 12 may evaporate the first target material at the evaporation power of 150 Kw.

Then the conveying assembly 11 starts to convey the base film XM. In some examples, the conveying assembly 11 may convey the base film XM at the speed of 10 m/min. At the same time, the ionization device 13 ionizes the vapor. The ionized vapor forms a first ionic layer Y1 on the first side s1 of the base film XM and then a second ionic layer Y2 to an n-th ionic layer Yn may be continuously formed on the first side s1 of the base film XM by the ionized vapor so as to form a first ionized structure YS. The ionization rate of the ionization device 13 is controlled by the control device 14 and the ionic layers Y1 to Yn may have completely different or partially different ionization rates.

In some examples, the control device 14 may automatically adjust the ionization rate of the ionization device 13 once per minute with the thickness of each ionic layer being about 5 nm. After the first ionized structure YS is completed, the control device 14 turns off the ionization device 13. In some examples, the first ionized structure YS includes at least one of aluminum, copper, nickel, tin, zinc, chromium, iron, lithium, cobalt and oxides or alloys thereof, or at least one of silicon oxide, silicon carbide, silicon nitride, graphite, carbon nanotubes and carbon fibers. In some examples, the thickness of the first ionized structure YS is less than 1,000 nm.

Finally, the second target material is placed in a crucible 121 and vaporized by a heating device (for example but not limited to an electronic gun) to produce a vapor. In some examples, the evaporation assembly 12 may evaporate the second target material at the evaporation power of 150 Kw. At the same time, the conveying assembly 11 synchronously conveys the base film XM. In some examples, the conveying assembly 11 conveys the base film XM at the speed of 20 m/min. The vapor of the second target material forms a metal layer Z including the second target material on the first ionized structure YS. In this way, the first side s1 of the base film XM is coated. In some examples, the thickness of the metal layer Z is smaller than 50 µm. In some examples, the thickness of the metal layer is about 1 µm. In some examples, the metal layer Z includes at least one of aluminum, copper, lithium and oxides or alloys thereof.

In some examples, the first ionized structure YS may be formed with a stack of three ionic layers as a primary circulation. When the primary circulation is performed, the first ionized structure YS includes three ionic layers; when a secondary circulation is performed, the first ionized structure YS includes six ionic layers, and so on. When the primary circulation is performed, step 22 may specifically include: the control device 14 controls the ionization device 13 to ionize the vapor of the first target material at a first ionization rate so as to form the first ionic layer Y1 on the first side s1 of the base film XM; then the control device 14 controls the ionization device 13 to ionize the vapor of the first target material at a second ionization rate so as to form the second ionic layer Y2 on the first ionic layer Y1; and finally, the control device 14 controls the ionization device 13 to ionize the vapor of the first target material at a third ionization rate so as to form the third ionic layer Y3 on the second ionic layer Y2. In some examples, the first, second and third ionization rates are different from each other.

However, the present application does not limit the number of the ionic layers included in the first ionized structure YS to be circulated on the basis of three layers. In other examples, only other number of the ionic layers may be included in the first ionized structure YS and the ionization rates of the ionic layers are completely different or partially different.

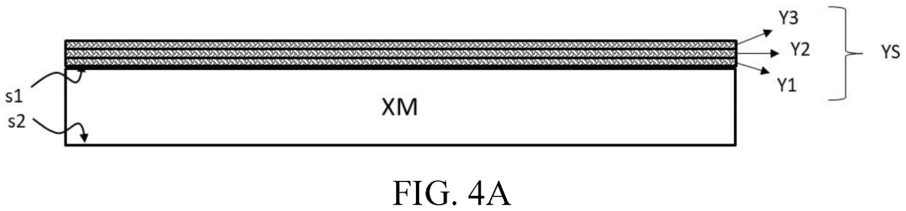

Referring to FIG. 4A, FIG. 4A is a structure diagram of a first ionized structure YS formed by a primary circulation according to an example of the present application. In the example of FIG. 4A, the first ionized structure YS includes a first ionic layer Y1, a second ionic layer Y2 and a third ionic layer Y3.

In some examples, the first ionization rate of the first ionic layer Y1, the second ionization rate of the second ionic layer Y2 and the third ionization rate of the third ionic layer Y3 increase progressively. In some examples, the first ionization rate of the first ionic layer Y1 is 40%, the second ionization rate of the second ionic layer Y2 is 60% and the third ionization rate of the third ionic layer Y3 is 80%.

In some examples, the first ionization rate of the first ionic layer Y1, the second ionization rate of the second ionic layer Y2 and the third ionization rate of the third ionic layer Y3 decrease progressively. In some examples, the first ionization rate of the first ionic layer Y1 is 80%, the second ionization rate of the second ionic layer Y2 is 60% and the third ionization rate of the third ionic layer Y3 is 40%.

In some examples, the first ionization rate of the first ionic layer Y1 and the third ionization rate of the third ionic layer Y3 are smaller than the second ionization rate of the second ionic layer Y2. In some examples, the first ionization rate of the first ionic layer Y1 is 40%, the second ionization rate of the second ionic layer Y2 is 80% and the third ionization rate of the third ionic layer Y3 is 60%. In some examples, the first ionization rate of the first ionic layer Y1 is 60%, the second ionization rate of the second ionic layer Y2 is 80% and the third ionization rate of the third ionic layer Y3 is 40%.

In some examples, the first ionization rate of the first ionic layer Y1 and the third ionization rate of the third ionic layer Y3 are greater than the second ionization rate of the second ionic layer Y2. In some examples, the first ionization rate of the first ionic layer Y1 is 80%, the second ionization rate of the second ionic layer Y2 is 40% and the third ionization rate of the third ionic layer Y3 is 60%. In some examples, the first ionization rate of the first ionic layer Y1 is 60%, the second ionization rate of the second ionic layer Y2 is 40% and the third ionization rate of the third ionic layer Y3 is 80%.

It should be noted that, the specific numbers of the first ionization rate, the second ionization rate and the third ionization rate are only exemplary, but are not a limitation of the present application.

When the secondary circulation is performed, step 22 may further specifically include: the control device 14 controls the ionization device 13 to ionize the vapor of the first target material at a fourth ionization rate so as to form the fourth ionic layer Y4 on the third ionic layer Y3; then the control device 14 controls the ionization device 13 to ionize the vapor of the first target material at a fifth ionization rate so as to form the fifth ionic layer Y5 on the fourth ionic layer Y4; and finally, the control device 14 controls the ionization device 13 to ionize the vapor of the first target material at a sixth ionization rate so as to form the sixth ionic layer Y6 on the fifth ionic layer Y5. In some examples, the fourth, fifth and sixth ionization rates are different from each other.

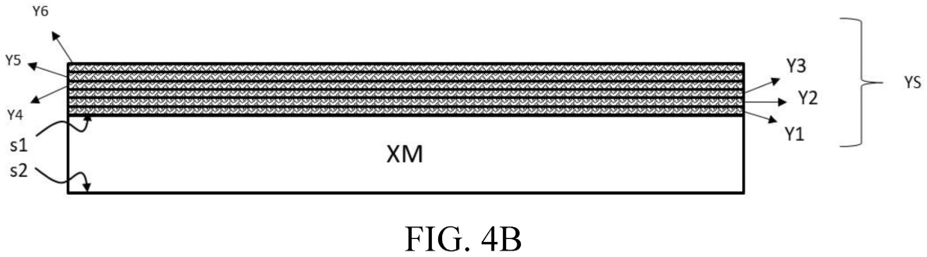

Referring to FIG. 4B, FIG. 4B is a structure diagram of a first ionized structure YS formed by a secondary circulation according to an example of the present application. In the example of FIG. 4B, the first ionized structure YS further includes the fourth ionic layer Y4, the fifth ionic layer Y5 and the sixth ionic layer Y6 in addition to the first ionic layer Y1, the second ionic layer Y2 and the third ionic layer Y3 in the example of FIG. 4A.

In some examples, the fourth ionization rate of the fourth ionic layer Y4, the fifth ionization rate of the fifth ionic layer Y5 and the sixth ionization rate of the sixth ionic layer Y6 increase progressively. In some examples, the fourth ionization rate of the fourth ionic layer Y4 is 40%, the fifth ionization rate of the fifth ionic layer Y5 is 60% and the sixth ionization rate of the sixth ionic layer Y6 is 80%.

In some examples, the fourth ionization rate of the fourth ionic layer Y4, the fifth ionization rate of the fifth ionic layer Y5 and the sixth ionization rate of the sixth ionic layer Y6 decrease progressively. In some examples, the fourth ionization rate of the fourth ionic layer Y4 is 80%, the fifth ionization rate of the fifth ionic layer Y5 is 60% and the sixth ionization rate of the sixth ionic layer Y6 is 40%.

In some examples, the fourth ionization rate of the fourth ionic layer Y4 and the sixth ionization rate of the sixth ionic layer Y6 are smaller than the fifth ionization rate of the fifth ionic layer Y5. In some examples, the fourth ionization rate of the fourth ionic layer Y4 is 40%, the fifth ionization rate of the fifth ionic layer Y5 is 80% and the sixth ionization rate of the sixth ionic layer Y6 is 60%. In some examples, the fourth ionization rate of the fourth ionic layer Y4 is 60%, the fifth ionization rate of the fifth ionic layer Y5 is 80% and the sixth ionization rate of the sixth ionic layer Y6 is 40%.

In some examples, the fourth ionization rate of the fourth ionic layer Y4 and the sixth ionization rate of the sixth ionic layer Y6 are greater than the fifth ionization rate of the fifth ionic layer Y5. In some examples, the fourth ionization rate of the fourth ionic layer Y4 is 80%, the fifth ionization rate of the fifth ionic layer Y5 is 40% and the sixth ionization rate of the sixth ionic layer Y6 is 60%. In some examples, the fourth ionization rate of the fourth ionic layer Y4 is 60%, the fifth ionization rate of the fifth ionic layer Y5 is 40% and the sixth ionization rate of the sixth ionic layer Y6 is 80%.

Similarly, the specific numbers of the fourth ionization rate, the fifth ionization rate and the sixth ionization rate are only exemplary, but are not a limitation of the present application.

It should be noted that the present application does not limit that the target material used in the primary circulation is the same as the target material used in the secondary circulation.

The examples of FIGs. 2, 3, 4A and 4B describe forming the first ionized structure YS on the first side s1 of the base film XM, the first target material is born by the crucible 121 of the evaporation assembly 12, the first target material is evaporated by the heating device of the evaporation assembly 12 to produce a vapor, and then the vapor is ionized by the ionization device 13 and the ionic layer having different ionization rates is formed on the first side s1 of the base film XM, thereby forming the first ionized structure YS.

The examples of FIGs. 2, 3, 4A and 4B do not limit the specific structure formed on the second side s2 of the base film XM. In some examples, the second side s2 of the base film XM may have the same, partially the same or completely different structure from the first side s1. As described in the example of FIG. 1, the first side s1 and the second side s2 of the base film XM may be coated by the crucibles 121 and 121' and the ionization devices 13 and 13' of the evaporation assembly 12 respectively or simultaneously.

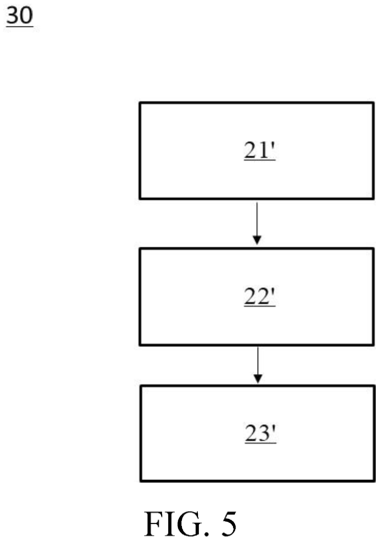

Referring to FIG. 5, FIG. 5 illustrates process steps of a method 30 for preparing a composite current collector for a lithium battery according to an example of the present application. In some examples, the apparatus 10 shown in FIG. 1 may be used to perform the process steps of the method 30. The present application does not limit the order of performing the method 30 and the method 20. In some examples, the method 20 may be performed first, followed by method 30, and vice versa. In some examples, the method 20 and the method 30 may be further performed simultaneously. The present application is not limited to being performed completely according to the process steps shown in FIG. 5, provided that substantially similar results are obtained. The method 30 may include steps 21', 22' and 23'. In step 21', the third target material may be evaporated to produce a third target material vapor. In step 22', the third target material vapor may be ionized to form a second ionized structure on a second side of a base film. The second ionized structure may include at least two ionic layers which respectively have different ionization rates. In step 23', a second target material may be evaporated to form a metal layer including the second target material on the second ionized structure.

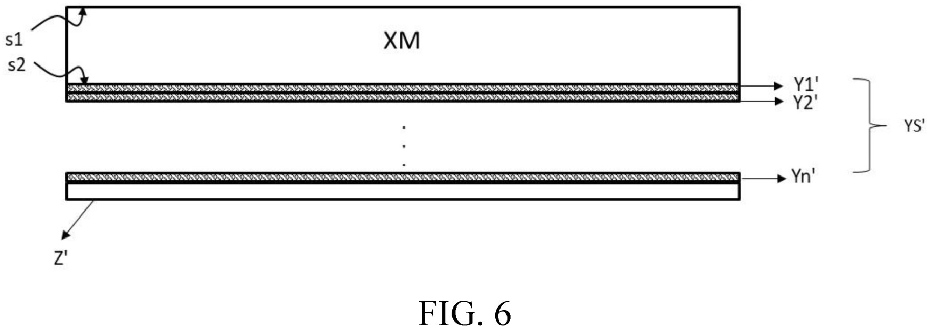

Referring to FIGs. 1, 5 and 6 together, FIG. 6 is a schematic diagram of a structure formed on a second side s2 of a base film XM according to an example of the present application. In some examples, the first target material and the third target material may be the same, such that the composition of the first ionized structure YS and the second ionized structure YS' is the same. In some examples, the first target material and the third target material may be the different, such that the composition of the first ionized structure YS and the second ionized structure YS' is different. In some examples, the first target material includes aluminum oxide and the third target material includes aluminum, such that the composition of the first ionized structure YS and the second ionized structure YS' is different.

In the process shown in the method 30, a third target material is placed in a crucible 121' and vaporized by a heating device (for example but not limited to an electronic gun) to produce a vapor of the third target material. In some examples, the evaporation assembly 12 may evaporate the third target material at the evaporation power of 150 Kw.

Then the conveying assembly 11 starts to convey the base film XM. In some examples, the conveying assembly 11 may convey the base film XM at the speed of 10 m/min. At the same time, the ionization device 13' respectively ionizes the vapor of the third target material. The ionized vapor of the third target material forms the seventh ionic layer Y1' on the second side s2 of the base film XM. Then the eighth ionic layer Y2' to the n'-th ionic layer Yn' may be continuously formed on the second side s2 of the base film XM by the ionized vapor of the third target material so as to form the second ionized structure YS'. The ionization rate of 13' is controlled by the control device 14 and the ionic layers Y1' to Yn' may have completely different or partially different ionization rates.

In some examples, the control device 14 may automatically adjust the ionization rate of the ionization device 13' once per minute with the thickness of each ionic layer being about 5 nm. After the second ionized structure YS' is completed, the control device 14 turns off the ionization device 13'. In some examples, the second ionized structure YS' includes at least one of aluminum, copper, nickel, tin, zinc, chromium, iron, lithium, cobalt and oxides or alloys thereof, or at least one of silicon oxide, silicon carbide, silicon nitride, graphite, carbon nanotubes and carbon fibers. In some examples, the thickness of the second ionized structure YS' is less than 1,000 nm.

Finally, the second target material is placed in a crucible 121' and vaporized by a heating device (for example but not limited to an electronic gun) to produce a vapor. In some examples, the evaporation assembly 12 may evaporate the second target material at the evaporation power of 150 Kw. At the same time, the conveying assembly 11 synchronously conveys the base film XM. In some examples, the conveying assembly 11 conveys the base film XM at the speed of 20 m/min. The vapor of the second target material forms a metal layer Z' including the second target material on the second ionized structure YS'. In this way, the second side s2 of the base film XM is coated. In some examples, the thickness of the metal layer Z' is smaller than 50 µm. In some examples, the thickness of the metal layer Z' is about 1 µm. In some examples, the metal layer Z' includes at least one of aluminum, copper, lithium and oxides or alloys thereof.

In some examples, the second ionized structure YS' may be formed with a stack of three ionic layers as a primary circulation. When the primary circulation is performed, the second ionized structure YS' includes three ionic layers; when a secondary circulation is performed, the second ionized structure YS' includes six ionic layers, and so on. When the primary circulation is performed, step 22' may specifically include: the control device 14 controls the ionization device 13' to ionize the vapor of the third target material at a seventh ionization rate so as to form the seventh ionic layer Y1' on the second side s2 of the base film XM; then the control device 14 controls the ionization device 13' to ionize the vapor of the third target material at an eighth ionization rate so as to form the eighth ionic layer Y2' on the seventh ionic layer Y1'; and finally, the control device 14 controls the ionization device 13' to ionize the vapor of the third target material at a ninth ionization rate so as to form the ninth ionic layer Y3' on the eighth ionic layer Y2'. In some examples, the seventh, eighth and ninth ionization rates are different from each other.

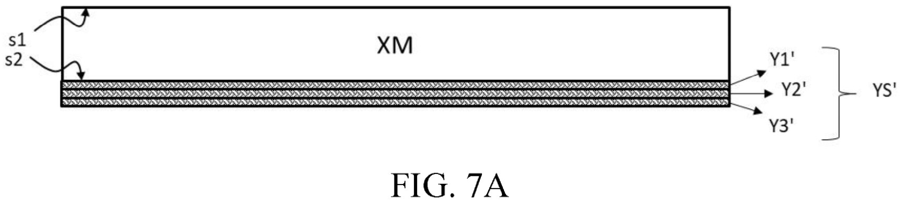

Referring to FIG. 7A, FIG. 7A is a structure diagram of a second ionized structure YS' formed by a primary circulation according to an example of the present application. In the example of FIG. 7A, the second ionized structure YS' includes the seventh ionic layer Y1', the eighth ionic layer Y2' and the ninth ionic layer Y3'.

In some examples, the seventh ionization rate of the seventh ionic layer Y1', the eighth ionization rate of the eighth ionic layer Y2' and the ninth ionization rate of the ninth ionic layer Y3' increase progressively. In some examples, the seventh ionization rate of the seventh ionic layer Y1' is 40%, the eighth ionization rate of the eighth ionic layer Y2' is 60% and the ninth ionization rate of the ninth ionic layer Y3' is 80%.

In some examples, the seventh ionization rate of the seventh ionic layer Y1', the eighth ionization rate of the eighth ionic layer Y2' and the ninth ionization rate of the ninth ionic layer Y3' decrease progressively. In some examples, the seventh ionization rate of the seventh ionic layer Y1' is 80%, the eighth ionization rate of the eighth ionic layer Y2' is 60% and the ninth ionization rate of the ninth ionic layer Y3' is 40%.

In some examples, the seventh ionization rate of the seventh ionic layer Y1' and the ninth ionization rate of the ninth ionic layer Y3' are smaller than the eighth ionization rate of the eighth ionic layer Y2'. In some examples, the seventh ionization rate of the seventh ionic layer Y1' is 40%, the eighth ionization rate of the eighth ionic layer Y2' is 80% and the ninth ionization rate of the ninth ionic layer Y3' is 60%. In some examples, the seventh ionization rate of the seventh ionic layer Y1' is 60%, the eighth ionization rate of the eighth ionic layer Y2' is 80% and the ninth ionization rate of the ninth ionic layer Y3' is 40%.

In some examples, the seventh ionization rate of the seventh ionic layer Y1' and the ninth ionization rate of the ninth ionic layer Y3' are greater than the eighth ionization rate of the eighth ionic layer Y2'. In some examples, the seventh ionization rate of the seventh ionic layer Y1' is 80%, the eighth ionization rate of the eighth ionic layer Y2' is 40% and the ninth ionization rate of the ninth ionic layer Y3' is 60%. In some examples, the seventh ionization rate of the seventh ionic layer Y1' is 60%, the eighth ionization rate of the eighth ionic layer Y2' is 40% and the ninth ionization rate of the ninth ionic layer Y3' is 80%.

It should be noted that, the specific numbers of the seventh ionization rate, the eighth ionization rate and the ninth ionization rate are only exemplary, but are not a limitation of the present application.

When the secondary circulation is performed, step 22' may further specifically include: the control device 14 controls the ionization device 13' to ionize the vapor of the third target material at a tenth ionization rate so as to form the tenth ionic layer Y4' on the ninth ionic layer Y3'; then the control device 14 controls the ionization device 13' to ionize the vapor of the third target material at an eleventh ionization rate so as to form the eleventh ionic layer Y5' on the tenth ionic layer Y4'; and finally, the control device 14 controls the ionization device 13' to ionize the vapor of the third target material at a twelfth ionization rate so as to form the twelfth ionic layer Y6' on the eleventh ionic layer Y5'. In some examples, the tenth, eleventh and twelfth ionization rates are different from each other.

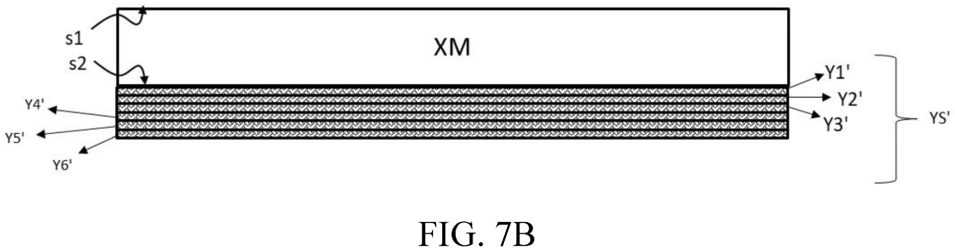

Referring to FIG. 7B, FIG. 7B is a structure diagram of a second ionized structure YS' formed by a secondary circulation according to an example of the present application. In the example of FIG. 7B, the second ionized structure YS' further includes the tenth ionic layer Y4', the eleventh ionic layer Y5' and the twelfth ionic layer Y6' in addition to the seventh ionic layer Y1', the eighth ionic layer Y2' and the ninth ionic layer Y3' in the example of FIG. 7A.

In some examples, the tenth ionization rate of the tenth ionic layer Y4', the eleventh ionization rate of the eleventh ionic layer Y5' and the twelfth ionization rate of the twelfth ionic layer Y6' increase progressively. In some examples, the tenth ionization rate of the tenth ionic layer Y4' is 40%, the eleventh ionization rate of the eleventh ionic layer Y5' is 60% and the twelfth ionization rate of the twelfth ionic layer Y6' is 80%.

In some examples, the tenth ionization rate of the tenth ionic layer Y4', the eleventh ionization rate of the eleventh ionic layer Y5' and the twelfth ionization rate of the twelfth ionic layer Y6' decrease progressively. In some examples, the tenth ionization rate of the tenth ionic layer Y4' is 80%, the eleventh ionization rate of the eleventh ionic layer Y5' is 60% and the twelfth ionization rate of the twelfth ionic layer Y6' is 40%.

In some examples, the tenth ionization rate of the tenth ionic layer Y4' and the twelfth ionization rate of the twelfth ionic layer Y6' are smaller than the eleventh ionization rate of the eleventh ionic layer Y5'. In some examples, the tenth ionization rate of the tenth ionic layer Y4' is 40%, the eleventh ionization rate of the eleventh ionic layer Y5' is 80% and the twelfth ionization rate of the twelfth ionic layer Y6' is 60%. In some examples, the tenth ionization rate of the tenth ionic layer Y4' is 60%, the eleventh ionization rate of the eleventh ionic layer Y5' is 80% and the twelfth ionization rate of the twelfth ionic layer Y6' is 40%.

In some examples, the tenth ionization rate of the tenth ionic layer Y4' and the twelfth ionization rate of the twelfth ionic layer Y6' are greater than the eleventh ionization rate of the eleventh ionic layer Y5'. In some examples, the tenth ionization rate of the tenth ionic layer Y4' is 80%, the eleventh ionization rate of the eleventh ionic layer Y5' is 40% and the twelfth ionization rate of the twelfth ionic layer Y6' is 60%. In some examples, the tenth ionization rate of the tenth ionic layer Y4' is 60%, the eleventh ionization rate of the eleventh ionic layer Y5' is 40% and the twelfth ionization rate of the twelfth ionic layer Y6' is 80%.

Similarly, the specific numbers of the tenth ionization rate, the eleventh ionization rate and the twelfth ionization rate are only exemplary, but are not a limitation of the present application.

It should be noted that the present application does not limit that the target material used in the primary circulation is the same as the target material used in the secondary circulation.

It will be understood by those skilled in the art that coating of the first side s1 and the second side s2 of the base film XM can be achieved by combining any one of the first ionized structures YS in the examples of FIGs. 4A and 4B and any one of the second ionized structures YS' in the examples of FIGs. 7A and 7B.

In some examples, the base film XM may be first pre-treated by plasma prior to performing the methods 20 and 30. Specifically, the plasma is generated by discharging a reaction gas (for example but not limited to Ar, O₂ and N₂) and contains high-energy substances such as electrons, ions, radicals and ultraviolet rays. The plasma acts on the base film XM, the contained active particles and high-energy rays contained are used and react and collide with organic pollutant molecules on the surface of the base film XM to form small-molecule volatile substances to remove the organic pollutant molecules from the surface, thereby achieving a cleaning effect and activating the surface.

Aiming at the first ionized structure YS and the second ionized structure YS' composed of the ionic layers having different ionization rates, the applicant performs a series of experiments to verify the relationship between different ionization rates, peel strength and tensile strength, wherein a peel strength test refers to GB/T 2792-2014 Measurement of peel adhesion properties for adhesive tapes and a tensile strength test is performed by using a universal experiment tensile machine according to GB/T 5230-2020 Electrodeposited copper foil for printed board. The experimental results are shown in Table 1 below.

**Table 1**

| | Peel strength (N/Cm) | Tensile strength (MPa) | | Elongation at break (%) | |
|---|---|---|---|---|---|
| | | MD | TD | MD | TD |
| Example 1 | 9.6 | 228 | 219 | 52.4 | 49.6 |
| Example 2 | 9.3 | 221 | 210 | 48.8 | 46.8 |
| Example 3 | 6.3 | 185 | 180 | 30.0 | 27.6 |
| Example 4 | 8.1 | 207 | 200 | 43.2 | 39.2 |
| Example 5 | 7.9 | 198 | 189 | 40.8 | 37.2 |
| Example 6 | 8.0 | 201 | 192 | 42.4 | 36.8 |
| Example 7 | 7.8 | 195 | 186 | 39.6 | 36.0 |
| Example 8 | 9.2 | 218 | 209 | 45.2 | 40.8 |

In example 1, the first ionized structure YS and the second ionized structure YS' are both subjected to twice circulation, each circulation includes three ionic layers, and the ionization rates all decrease progressively by 80%, 60% and 40%.

In example 2, the first ionized structure YS and the second ionized structure YS' each include only one ionic layer having the ionization rate of 80%.

In example 3, the first ionized structure YS and the second ionized structure YS' are both subjected to twice circulation, each circulation includes three ionic layers, and the ionization rates all increase progressively by 40%, 60% and 80%.

In example 4, the first ionized structure YS and the second ionized structure YS' are both subjected to twice circulation, and each circulation includes three ionic layers, wherein the ionization rates of the three ionic layers of the first ionized structure YS all increase progressively by 40%, 60% and 80%, and the ionization rates of the three ionic layers of the second ionized structure YS' all decrease progressively by 80%, 60% and 40%.

In example 5, the first ionized structure YS and the second ionized structure YS' are both subjected to twice circulation, and each circulation includes three ionic layers, wherein the ionization rates of the three ionic layers of the first ionized structure YS change by 40%, 80% and 60%, and the ionization rates of the three ionic layers of the second ionized structure YS' change by 80%, 40% and 60%.

In example 6, the first ionized structure YS and the second ionized structure YS' are both subjected to twice circulation, and each circulation includes three ionic layers, wherein the ionization rates of the three ionic layers of the first ionized structure YS in the primary circulation increase progressively by 40%, 60% and 80%, and the ionization rates of the three ionic layers in the secondary circulation decrease progressively by 80%, 60% and 40%; and the ionization rates of the three ionic layers of the second ionized structure YS' in the primary circulation decrease progressively by 80%, 60% and 40%, and the ionization rates of the three ionic layers in the secondary circulation increase progressively by 40%, 60% and 80%.

In example 7, the first ionized structure YS is subjected to a primary circulation and the second ionized structure YS' is subjected to twice circulation, and each circulation includes three ionic layers, wherein the ionization rates of the three ionic layers of the first ionized structure YS increase progressively by 40%, 60% and 80%, and the ionization rates of the three ionic layers of the second ionized structure YS' decrease progressively by 80%, 60% and 40%.

In example 8, the first ionized structure YS and the second ionized structure YS' are both subjected to twice circulation, each circulation includes three ionic layers, and the ionization rates all decrease progressively by 80%, 60% and 40%. The first target material uses an aluminum oxide target material and the third target material uses an aluminum target material.

In the examples, the compactness of the coating layer close to the base film is higher (i.e., the ionization rate is higher), the adhesive force is better and the mechanical properties are better. Meanwhile, the addition of the metal oxide can enhance the corrosion resistance without much change in the mechanical properties.

The composite current collector prepared by the method and the apparatus provided by the present application consists of a high polymer base film, metal/nonmetal coating layers on two sides of the base film, and a metal layer on the outermost layer. The intermediate coating layer group is composed of deposition of ionic layers having different ionization rates, and a plurality of similar circulated coating films can exist in a required thickness range. The intermediate layer group is prepared by adjusting the ionization rate in the evaporation process, such that the bonding force between the base film and the subsequent metal layer is enhanced, the compactness is good and the internal stress of the film layer is improved.

As used herein, the terms "approximately", "substantially", "essentially" and "about" are used to describe and account for minor variations. When used in conjunction with an event or circumstance, the terms may refer to examples of the exact occurrence of the event or circumstance as well as the extremely approximate occurrence of the event or circumstance. As used herein with respect to a given value or range, the term "about" generally means within ±10%, ±5%, ±1% or ±0.5% of the given value or range. The range may be expressed herein as from one endpoint to the other endpoint, or between two endpoints. Unless otherwise specified, all ranges disclosed herein are inclusive of the endpoints. The term "substantially coplanar" may refer to two surfaces located within a few micrometers (µm) along the same plane, e.g., within 10 µm, within 5 µm, within 1 µm or within 0.5 µm located along the same plane. When referring to "substantially" same numerical values or properties, the term may refer to values within ±10%, ±5%, ±1% or ±0.5% of the mean of the values.

As used herein, the terms "approximately", "substantially", "essentially" and "about" are used to describe and explain minor variations. When used in conjunction with an event or circumstance, the terms may refer to examples of the exact occurrence of the event or circumstance as well as the extremely approximate occurrence of the event or circumstance. For example, when used in conjunction with the numerical values, the terms may refer to a range of variation of less than or equal to ±10% of the numerical values, e.g., less than or equal to ±5%, less than or equal to ±4%, less than or equal to ±3%, less than or equal to ±2%, less than or equal to ±1%, less than or equal to ±0.5%, less than or equal to ±0.1%, or less than or equal to ±0.05%. For example, if the difference between the two numerical values is less than or equal to ±10% (e.g., less than or equal to ±5%, less than or equal to ±4%, less than or equal to ±3%, less than or equal to ±2%, less than or equal to ±1%, less than or equal to ±0.5%, less than or equal to ±0.1%, or less than or equal to ±0.05%) of the mean of the values, two numerical values may be considered "substantially' or "about" the same. For example, "substantially" parallel may refer to a range of angular variation of less than or equal to ±10° relative to 0°, e.g., less than or equal to ±5°, less than or equal to ±4°, less than or equal to ±3°, less than or equal to ±2°, less than or equal to ±1°, less than or equal to ±0.5°, less than or equal to ±0.1°, or less than or equal to ±0.05°. For example, "substantially" perpendicular may refer to a range of angular variation of less than or equal to ±10° relative to 90°, e.g., less than or equal to ±5°, less than or equal to ±4°, less than or equal to ±3°, less than or equal to ±2°, less than or equal to ±1°, less than or equal to ±0.5°, less than or equal to ±0.1°, or less than or equal to ±0.05°.

For example, if the displacement between the two surfaces is equal to or less than 5 µm, equal to or less than 2 µm, equal to or less than 1 µm, or equal to or less than 0.5 µm, the two surfaces may be considered coplanar or substantially coplanar. If the displacement of the surface relative to the plane between any two points on the surface is equal to or less than 5 µm, equal to or less than 2 µm, equal to or less than 1 µm, or equal to or less than 0.5 µm, the surface may be considered planar or substantially planar.

As used herein, the singular terms "a/an" and "the" may include the plural referents unless the context clearly dictates otherwise. In the description of some examples, a component arranged "on" or "over" another component may encompass the case where the preceding component is directly on (e.g., in physical contact with) the succeeding component, as well as the case where one or more intermediate components are located between the preceding component and succeeding component.

As used herein, spatially relative terms, such as "below", "under", "lower", "above", "upper", "left", "right" and the like, may be used herein for ease description of the relationship between one component or feature and another component or feature as illustrated in the figures. Spatially relative terms are intended to encompass different orientations of the apparatus in use or operation in addition to the orientation described in the figures. The apparatus may be otherwise oriented (rotated 90 degrees or at other orientations) and the spatially relative descriptors used herein may be interpreted accordingly. It will be understood that when a component is referred to as being "connected" or "coupled" to the other component, it can be directly connected or coupled to the other component or intermediate components may be present.

The foregoing has outlined features of several examples and detailed aspects of the present disclosure. The examples described in the present disclosure can be readily used as a basis for designing or modifying other processes and structures for performing the same or similar purposes and/or obtaining the same or similar advantages of the examples introduced herein. Such equivalent constructions do not depart from the spirit and scope of the present disclosure and various changes, substitutions and alterations can be made therein without departing from the spirit and scope of the present disclosure.

## Claims

1. A method for preparing a composite current collector for a lithium battery, comprising:
evaporating a first target material to produce a first target material vapor;
ionizing the first target material vapor to form a first ionized structure on a first side of a base film, wherein the first ionized structure comprises at least two ionic layers which respectively have different ionization rates; and
evaporating a second target material to form a metal layer comprising the second target material on the first ionized structure.

2. The method according to claim 1, wherein ionizing the first target material vapor to form the first ionized structure on the first side of the base film comprises:
forming a first ionic layer on the first side of the base film;
forming a second ionic layer on the first ionic layer; and
forming a third ionic layer on the second ionic layer,
wherein the ionization rates of the first, second and third ionic layers are different from each other.

3. The method according to claim 2, wherein the ionization rates of the first, second and third ionic layers increase progressively.

4. The method according to claim 2, wherein the ionization rates of the first, second and third ionic layers decrease progressively.

5. The method according to claim 2, wherein the ionization rates of the first and third ionic layers are smaller than the ionization rate of the second ionic layer.

6. The method according to claim 2, wherein the ionization rates of the first and third ionic layers are greater than the ionization rate of the second ionic layer.

7. The method according to claim 2, wherein ionizing the first target material vapor to form the first ionized structure on the first side of the base film comprises:
forming a fourth ionic layer on the third ionic layer,
forming a fifth ionic layer on the fourth ionic layer; and
forming a sixth ionic layer on the fifth ionic layer,
wherein the ionization rates of the fourth, fifth and sixth ionic layers are different from each other.

8. The method according to claim 7, wherein the ionization rates of the fourth, fifth and sixth ionic layers increase progressively.

9. The method according to claim 7, wherein the ionization rates of the fourth, fifth and sixth ionic layers decrease progressively.

10. The method according to claim 7, wherein the ionization rates of the fourth and sixth ionic layers are smaller than the ionization rate of the fifth ionic layer.

11. The method according to claim 7, wherein the ionization rates of the fourth and sixth ionic layers are greater than the ionization rate of the fifth ionic layer.

12. The method according to any one of claims 1 to 11, further comprising:
evaporating a third target material to produce a third target material vapor;
ionizing the third target material vapor to form a second ionized structure on a second side of the base film, wherein the second side is opposite to the first side and the second ionized structure comprises at least two ionic layers which respectively have different ionization rates; and
evaporating the second target material to form a metal layer comprising the second target material on the second ionized structure.

13. The method according to claim 12, wherein forming the second ionized structure on the second side of the base film comprises:
forming a seventh ionic layer on the second side of the base film;
forming an eighth ionic layer on the seventh ionic layer; and
forming a ninth ionic layer on the eighth ionic layer,
wherein the ionization rates of the seventh, eighth and ninth ionic layers are different from each other.

14. The method according to claim 13, wherein the ionization rates of the seventh, eighth and ninth ionic layers increase progressively.

15. The method according to claim 13, wherein the ionization rates of the seventh, eighth and ninth ionic layers decrease progressively.

16. The method according to claim 13, wherein the ionization rates of the seventh and ninth ionic layers are smaller than the ionization rate of the eighth ionic layer.

17. The method according to claim 13, wherein the ionization rates of the seventh and ninth ionic layers are greater than the ionization rate of the eighth ionic layer.

18. The method according to claim 13, wherein forming the second ionized structure on the second side of the base film further comprises:
forming a tenth ionic layer on the ninth ionic layer;
forming an eleventh ionic layer on the tenth ionic layer; and
forming a twelfth ionic layer on the eleventh ionic layer,
wherein the ionization rates of the tenth, eleventh and twelfth ionic layers are different from each other.

19. The method according to claim 18, wherein the ionization rates of the tenth, eleventh and twelfth ionic layers increase progressively.

20. The method according to claim 18, wherein the ionization rates of the tenth, eleventh and twelfth ionic layers decrease progressively.

21. The method according to claim 18, wherein the ionization rates of the tenth and twelfth ionic layers are smaller than the ionization rate of the eleventh ionic layer.

22. The method according to claim 18, wherein the ionization rates of the tenth and twelfth ionic layers are greater than the ionization rate of the eleventh ionic layer.

23. The method according to claim 12, wherein the first, second and third target materials are the same, partially the same or different from each other.

24. The method according to claim 12, wherein the first target material comprises aluminum oxide and the third target material comprises aluminum.

25. The method according to claim 1, wherein the base film comprises any one or a mixture of more than one of polypropylene, polyethylene terephthalate, polybutylene terephthalate, polyethylene naphthalate, polyethylene, polystyrene, polyvinyl chloride, polyvinylidene fluoride, polytetrafluoroethylene, polyphenylene sulfide, polyphenylene oxide, polyacrylonitrile, cellulose acetate, polystyrene or polyimide.

26. The method according to claim 1, wherein the first ionized structure comprises at least one of aluminum, copper, nickel, tin, zinc, chromium, iron, lithium, cobalt and oxides or alloys thereof, or at least one of silicon oxide, silicon carbide, silicon nitride, graphite, carbon nanotubes and carbon fibers.

27. The method according to claim 1, wherein the thickness of the first ionized structure is less than 1,000 nm.

28. The method according to claim 1, wherein the metal layer comprises at least one of aluminum, copper, lithium and oxides or alloys thereof.

29. The method according to claim 1, wherein the thickness of the metal layer is smaller than 50 µm.

30. An apparatus for preparing a composite current collector for a lithium battery, configured to perform the method according to claim 1, comprising:
a conveying assembly to convey a base film;
an evaporation assembly arranged below the conveying assembly and configured to evaporate a target material; and
an ionization device arranged above the evaporation assembly and configured to ionize vapor of the target material to form at least two ionic layers on the base film, wherein the at least two ionic layers respectively have different ionization rates,
wherein the conveying assembly comprises conveying rollers configured to bear the base film so as to enable a film to be coated of the base film to face towards the evaporation assembly and the ionization device, and the conveying rollers comprise cooling components configured to control the temperature of the base film when the base film is coated so as to avoid the base film from being overheat-shrunk and deformed due to the formation of the at least two ionic layers having different ionization rates.
